# FASCICULE DE BREVET EUROPEEN

(11) **EP 3 758 173 B1**
(45) Date de publication et mention de la délivrance du brevet: **30.03.2022**
(21) Numéro de dépôt: 20181582.6
(22) Date de dépôt: 23.06.2020
(51) Int. Cl.: H02B 1/01, H02B 1/30, F16B 25/00, F16B 13/12, F16B 21/06, H02B 1/16

(54) **ARMOIRE ÉLECTRIQUE AVEC PANNEAU RAPPORTÉ**
SCHALTSCHRANK MIT AUFGESETZTER ABDECKUNG
ELECTRICAL CABINET WITH ATTACHED PANEL

(30) Priorité: 24.06.2019 FR 1906788
(43) Date de publication de la demande: 30.12.2020
(73) Titulaire: Schneider Electric Industries SAS, 92500 Rueil Malmaison (FR)
(72) Inventeur: GUINEBERT, Patrick, 38050 GRENOBLE CEDEX 09 (FR)
(74) Mandataire: Lavoix

(56) Documents cités:
- WO-A1-2017/182028
- DE-C1- 19 525 851
- DE-U1- 29 614 146
- US-A- 4 329 823
- US-B2- 8 661 755

## Description

La présente invention concerne une armoire électrique qui comprend une armature et au moins un panneau rapporté sur cette armature au moyen d'une vis auto-taraudeuse.

Au sens de la présente invention, une armoire électrique est une armoire destinée à contenir des appareils électriques pour la répartition de courant ou le contrôle d'une machine. Ces appareils électriques peuvent comprendre des répartiteurs de courant, des disjoncteurs, des automates ainsi que d'autres matériels.

DE 296 14 146 U1 divulgue la fixation d'un panneau d'armoire électrique à un montant du cadre de cette armoire. Cette fixation est effectuée au moyen d'une vis fixée à une douille d'écartement. DE 195 25 851 C1 divulgue une autre solution de fixation d'un panneau à un cadre d'une armoire au moyen d'une vis auto-taraudeuse.

Il est connu de fabriquer des armoires électriques à partir d'une armature, le plus souvent métallique, sur laquelle sont rapportés des panneaux qui obturent les faces de cette armoire, tout en laissant une face libre pour la mise en place d'une porte articulée sur l'armature. Une façon connue de fixer un panneau sur l'armature d'une armoire électrique consiste à introduire des vis dans des orifices ménagés dans ce panneau et à visser ces vis, le plus souvent auto-taraudeuses, dans l'armature. Des pré-perçages peuvent être prévus dans l'armature pour y visser les vis, mais il n'est pas certain que les vis soient correctement alignées avec ces pré-perçages, de sorte que, même si un effort de vissage calibré est utilisé, l'effort exercé par chacune des vis pour plaquer le panneau sur l'armature peut être trop important ou pas assez important, ce qui peut induire une déformation plastique du panneau ou, au contraire, son maintien de façon non pérenne sur l'armature. En l'absence d'effort de plaquage suffisant du panneau sur l'armature, un joint, porté par ce panneau ou par cette armature pour assurer l'étanchéité entre le volume intérieur de l'armoire électrique et l'extérieur, peut ne pas être comprimé de façon suffisante, au point qu'il n'assure pas nécessairement sa fonction. En outre, dans les matériels connus, une liaison équipotentielle entre un panneau et l'armature est le plus souvent réalisée au moyen de câbles électriques qui doivent être raccordés à chacun de ces matériels lors du montage et séparés de l'un au moins de ces matériels lors d'un démontage de l'armoire, ce qui s'avère fastidieux.

C'est à ces inconvénients qu'entend plus particulièrement remédier l'invention en proposant une nouvelle armoire électrique plus facile et plus rapide à assembler, tout en assurant une compression adéquate d'un joint d'étanchéité disposé entre un panneau et l'armature de cette armoire et en réalisant une liaison équipotentielle entre ces éléments.

A cet effet, l'invention concerne une armoire électrique comprenant une armature et au moins un panneau rapporté sur cette armature au moyen d'au moins une vis auto-taraudeuse qui traverse un orifice ménagé dans le panneau et qui est vissée dans l'armature. Selon l'invention, l'armoire comprend également une douille de pré-positionnement de la vis par rapport à l'orifice du panneau. La vis peut être reçue dans la douille dans une première configuration, où un axe longitudinal de la vis s'étend selon un axe défini par la douille, et une deuxième configuration, où une extrémité d'une tige de la vis opposée à une tête de cette vis dépasse plus de la douille, le long de l'axe défini par la douille, que dans la première configuration. La vis porte une butée de limitation de son enfoncement par vissage dans l'armature, ainsi qu'un relief pour le retrait localisé d'une couche de revêtement appliquée sur le panneau. La douille est pourvue d'un logement de réception de chaque relief de la vis disposé de telle sorte que, lorsque la vis est dans sa deuxième configuration, le relief fait saillie à l'extérieur de la douille en direction du panneau.

Grâce à l'invention, la douille permet de pré-positionner la vis par rapport à l'orifice du panneau dans lequel elle est introduite, ce qui évite de visser la vis de biais dans l'armature de l'armoire. En outre, la butée prévue sur la vis permet de limiter l'enfoncement de la vis dans l'armature lors de son vissage, ce qui évite que le panneau soit déformé plastiquement au voisinage de son orifice sous l'action d'un effort de vissage qui pourrait être trop important. D'autre part, la butée permet à l'utilisateur de savoir quand il a atteint une position de serrage suffisante de la vis dans l'armature, au point qu'un joint disposé à l'interface entre le panneau et l'armature est comprimé de façon satisfaisante. Enfin, le relief de retrait localisé d'une couche de revêtement permet, lors du vissage de la vis sur l'armature, de rayer ou de retirer un revêtement tel qu'une peinture ou un vernis appliqué sur le panneau, de telle sorte qu'une liaison équipotentielle est réalisée entre la vis et le panneau. D'autre part, comme la vis est vissée dans l'armature, une liaison équipotentielle est également réalisée entre la vis et l'armature. Le relief prévu sur la vis permet donc, à travers celle-ci, de réaliser une liaison équipotentielle entre le panneau et l'armature, sans avoir à utiliser un câble électrique.

Selon des aspects avantageux mais non obligatoires de l'invention, une telle armoire peut incorporer une ou plusieurs des caractéristiques suivantes, prises selon toute combinaison techniquement admissible :
- La douille comprend une portion d'appui surfacique contre le panneau, à la périphérie de l'orifice.
- La douille est pourvue d'un volume de réception et de pincement d'un bord de l'orifice et, lors du passage de la vis de la première configuration à la deuxième configuration, un effort de pincement du bord de l'orifice par la douille augmente.
- La butée est formée par une collerette périphérique ménagée sur la tige de la vis.
- Dans la première configuration, la vis est immobilisée dans la douille par coopération de formes entre la collerette et un logement de forme correspondante ménagé dans la douille.
- La vis porte plusieurs reliefs de retrait localisé de la couche de revêtement formés par des dents disposées autour de sa tige, au voisinage de sa tête et les dents sont configurées pour, lorsque la douille est montée sur le panneau et lorsque la vis est dans la deuxième configuration, venir racler le bord de l'orifice, plus particulièrement une arête de jonction entre ce bord et une surface du panneau.
- La douille comprend une partie annulaire qui définit un logement de réception partielle de la tête de la vis et plusieurs pattes qui définissent ensemble l'axe défini par la douille.
- Les pattes sont reliées par des pontets sécables qui sont rompus lorsque la vis passe de la première configuration à la deuxième configuration, dans la douille.
- Les logements de réception des dents formant les reliefs de retrait localisé de la couche de revêtement sont décalés angulairement, autour de l'axe défini par la douille, par rapport aux pattes.
- La douille est une pièce monobloc en matériau synthétique, notamment en polyamide.

L'invention sera mieux comprise et d'autres avantages de celle-ci apparaîtront plus clairement à la lumière de la description qui va suivre d'un mode de réalisation d'une armoire électrique conforme à son principe, donnée uniquement à titre d'exemple et faite en référence aux dessins annexés, dans lesquels :
[Fig 1] la figure 1 est une vue en perspective, avec arrachement partiel, d'une armoire électrique conforme à l'invention ;
[Fig 2] la figure 2 est une vue en perspective de la même armoire dont un panneau latéral et la porte ont été retirés ;
[Fig 3] la figure 3 est une vue à plus grande échelle du détail III à la figure 1 ;
[Fig 4] la figure 4 est une vue en perspective d'un sous-ensemble formé d'une vis et d'une douille appartenant à l'armoire des figures 1 à 3 en cours d'insertion dans un orifice d'un panneau de cette armoire ;
[Fig 5] la figure 5 est une vue en perspective éclatée du sous-ensemble de la figure 4 ;
[Fig 6] la figure 6 est une coupe selon le plan VI à la figure 4 lorsque la vis commence à pénétrer dans l'orifice ;
[Fig 7] la figure 7 est une coupe partielle à plus grande échelle selon le plan VII à la figure 1, lorsque le sous-ensemble de la figure 4 formé de la douille et de la vis est pré-monté sur le panneau et la vis non encore vissée dans l'armature ;
[Fig 8] la figure 8 est une coupe dans le même plan que la figure 7 lorsque la vis est vissée dans l'armature ; et
[Fig 9] la figure 9 est une coupe dans un plan parallèle à celui des figures 7 et 8 qui comprend l'axe longitudinal de la vis lorsque la vis est vissée dans l'armature, comme à la figure 8.

L'armoire 2 représentée sur les figures comprend une armature 22 formée d'une structure métallique comprenant des montants 222 et des traverses 224, les montants étant sensiblement verticaux alors que les traverses sont sensiblement horizontales en configuration installée de l'armoire sur un sol plan.

L'armoire 2 comprend également un certain nombre de panneaux 24 qui sont rapportés sur l'armature 22 et qui définissent les deux côtés latéraux gauche et droit de l'armoire 2, son fond, son plafond et son plancher.

L'armoire 2 comprend également une porte 26 articulée sur l'armature 22, d'une façon connue en soi, qui permet d'accéder au volume intérieur de l'armoire 2 lorsque cette porte est ouverte.

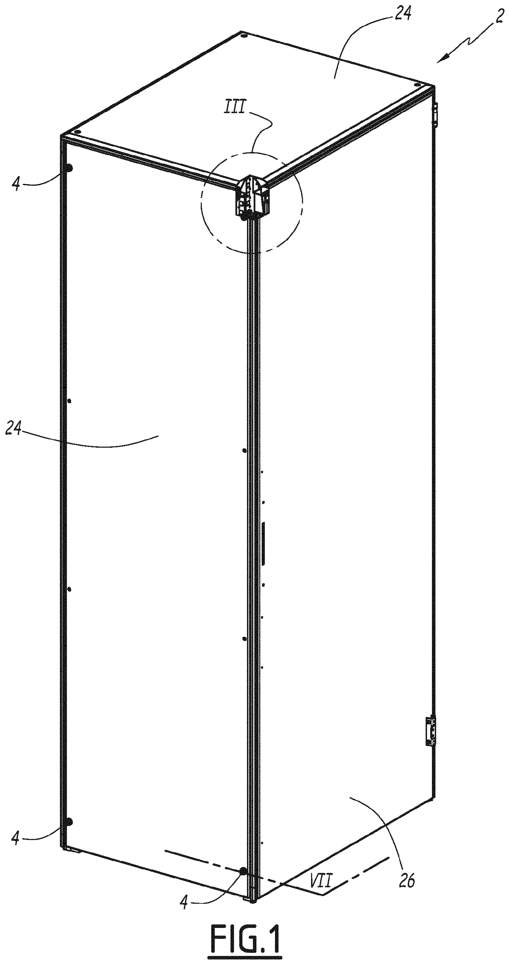

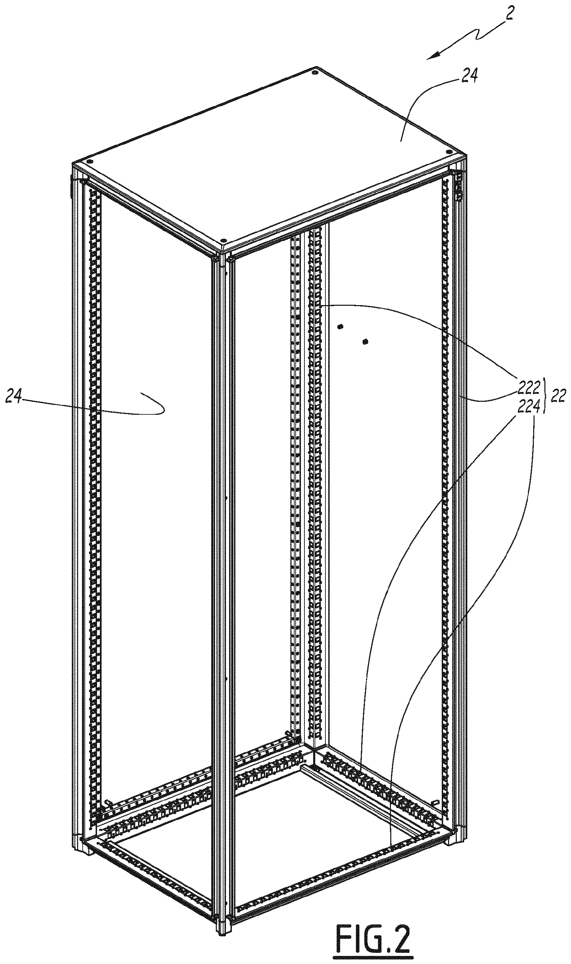

Dans ce qui suit, on décrit plus particulièrement la façon dont le panneau 24 gauche de l'armoire 2 est rapporté sur l'armature 22, ce panneau étant visible aux figures 1 et 2. Cette description s'applique, par transposition, aux autres panneaux 24.

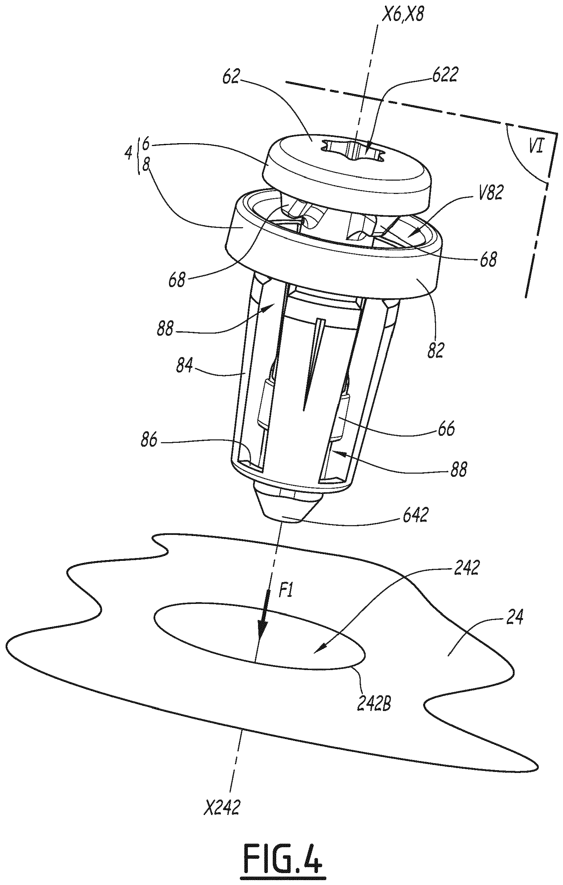

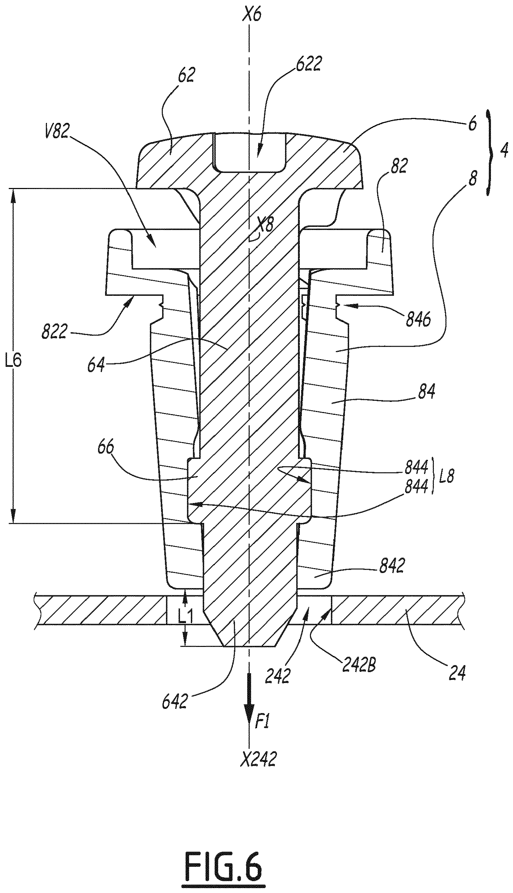

Le panneau 24 est pourvu de huit orifices 242 répartis le long de ses bords longitudinaux, l'un de ces orifices étant plus particulièrement visible aux figures 4 et 6. Chacun de ces orifices est à section circulaire et centré sur un axe X242.

En configuration montée de l'armoire 2, un sous-ensemble 4 est inséré dans chaque orifice 242, ce sous-ensemble 4 étant formé d'une vis métallique 6 et d'une douille monobloc 8 en matériau synthétique, par exemple en polyamide.

La vis 6 est formée d'une tête 62 et d'une tige 64. On note 642 l'extrémité de la tige opposée à la tête 62. Cette extrémité est pourvue d'un filetage trilobé qui permet à la vis 6 de créer un taraudage lorsqu'elle est vissée dans une pièce métallique. En ce sens, la vis 6 est une vis auto-taraudeuse.

La tête 62 est pourvue d'une empreinte polygonale 622.

On note X6 l'axe longitudinal de la vis 6. L'empreinte 622 permet d'exercer, sur la vis 6 et au moyen d'un outil adapté, un couple d'entraînement en rotation de cette vis 6 autour de l'axe X6, pour son vissage ou son dévissage sur une structure voisine.

La vis 6 comprend également une collerette 66 disposée le long de la tige 64 et qui présente un diamètre plus important que le reste de la tige 64. On note L6 une longueur, mesurée parallèlement à l'axe X6, entre la tête 62 et un épaulement formé entre la collerette 66 et la tige 64 du côté de l'extrémité 642.

La vis 6 porte également quatre dents 68 qui sont disposées sous la tête 62, autour de la tige 64.

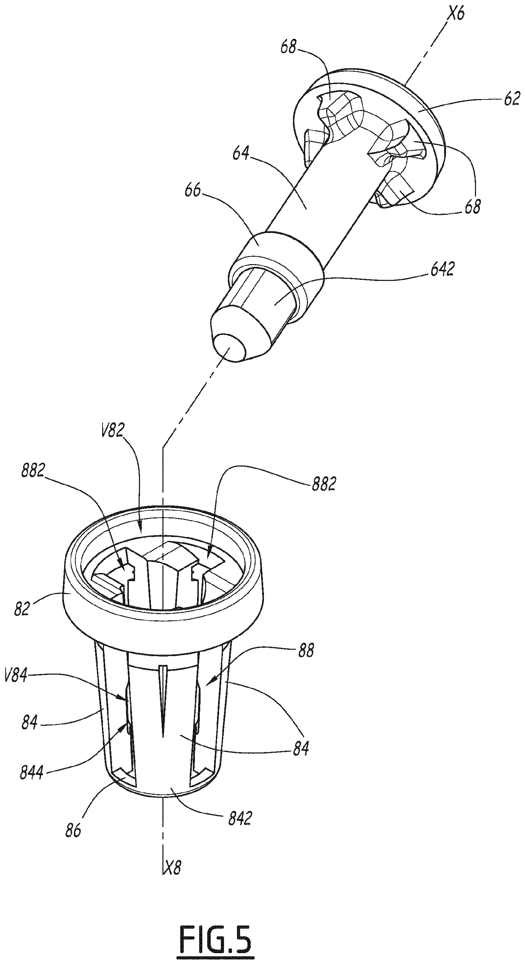

La douille 8 comprend une partie annulaire 82 centrée sur un axe X8 qui est un axe central de la douille 8 et autour duquel sont régulièrement réparties quatre pattes 84 qui s'étendent du même côté de la partie annulaire 82 et dont on note 842 les extrémités opposées à la partie annulaire 82. Dans la configuration des figures 4 à 7, les extrémités 842 de deux pattes 84 adjacentes sont reliées entre elles par un pontet sécable 86.

La partie annulaire 82 définit un volume V82 de réception d'une partie de la tête 62 de la vis 6. En variante, le volume V82 peut recevoir la totalité de la tête 62.

Des fentes 88 sont définies entre deux pattes 84 adjacentes ; ces fentes s'étendent chacune, le long de l'axe X8, entre la collerette 82 et un pontet 86.

On note 882 la portion d'une fente 88 qui débouche dans le volume V82. Chacune des portions 882 constitue un logement de réception d'une dent 68 lorsque la tête 62 de la vis 6 est reçue dans le volume V82. Du fait qu'ils constituent les portions supérieures des fentes 88, les logements 882 de réception des dents 68 sont décalés angulairement, autour de l'axe X8, par rapport aux pattes 84.

On note V84 un volume défini entre les pattes 84, autour de l'axe X8, entre la partie annulaire 82 et les pontets 86. En configuration pré-montée de la vis 6 dans la douille 8, telle que représentée aux figures 4 et 6 et 7, une partie de la tige 64 est reçue dans le volume V84.

Comme cela ressort plus particulièrement de la figure 6, chacune des pattes 84 est pourvue, sur son côté orienté vers l'axe X8, d'une encoche 844 de réception d'un secteur angulaire de la collerette 66 lorsque la vis 6 est en configuration pré-montée dans la douille 8, cette configuration pré-montée constituant une première configuration de positionnement de la vis 6 par rapport à la douille 8 et étant représentée aux figures 4, 6 et 7.

Les quatre encoches 844 des quatre pattes 84 constituent ensemble un logement L8 de réception de la collerette 66.

En pratique, une section d'une encoche 844 radiale à l'axe X8 est complémentaire d'une section de la collerette 66 radiale à l'axe X6, au point que, dans la première configuration, la vis 6 est immobilisée dans la douille 8 par coopération de formes entre la collerette 66 et le logement L8 formé des encoches 844.

Dans cette première configuration, les axes X6 et X8 sont alignés et l'extrémité 642 de la tige 64 dépasse de la douille 8 sur une première longueur L1 mesurée parallèlement aux axes X6 et X8.

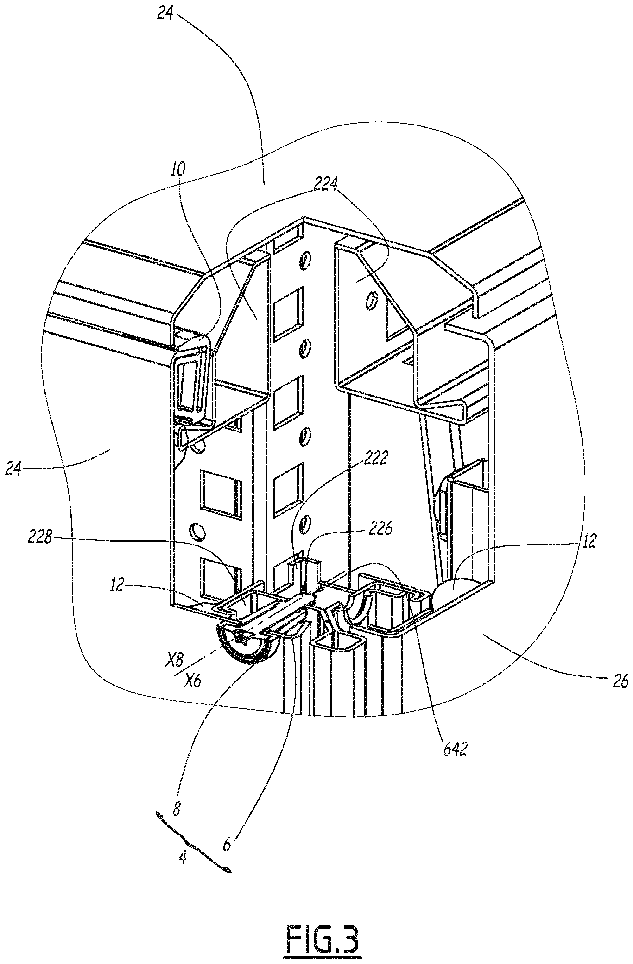

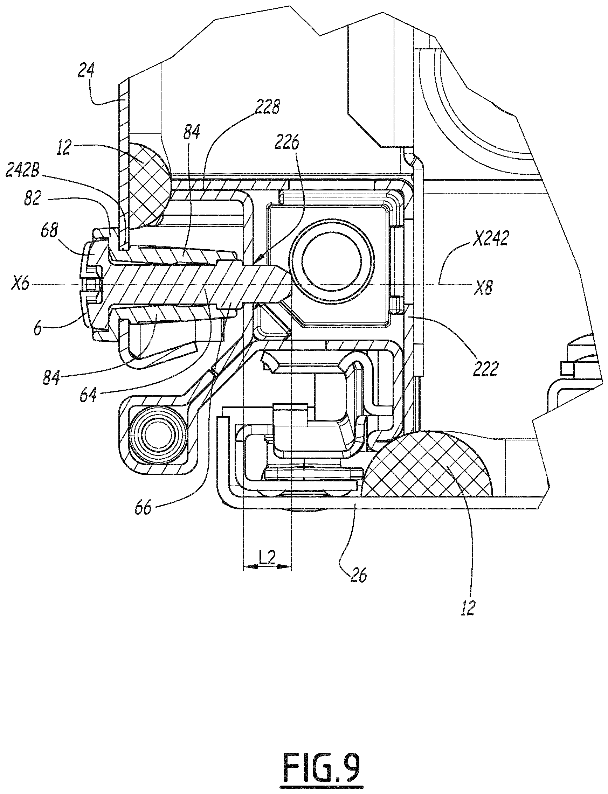

D'autre part, chaque montant 222 est prévu de pré-perçages, dont un est visible aux figures 3 et 9 et vis-à-vis desquels il convient de positionner une vis 6 avant son vissage sur ce montant. Lorsqu'il convient d'assembler l'armoire 2, en rapportant le panneau de gauche 24 sur l'armature 22, un sous-ensemble 4, avec sa vis 6 dans la première configuration par rapport à sa douille 8, est introduit dans chacun des orifices 242 en alignant les axes X6 et X8 sur l'axe X242 de cet orifice et en poussant le sous-ensemble 4 à travers l'orifice 242, le long de l'axe X242, comme représenté par les flèches F1 aux figures 4 et 6. La douille 8 pénètre alors dans l'orifice 242 jusqu'à ce qu'une surface annulaire et plane 822 de la partie annulaire 82, qui est orientée vers les extrémités 842 des pattes 84, vienne en appui surfacique contre le panneau 24, qui est également plan autour de l'orifice 242, autour du bord 242B de l'orifice 242. La surface 822 est alors en appui surfacique contre le panneau 24 , ce qui garantit que le sous-ensemble 4 est positionné de façon pérenne par rapport au panneau.

Comme visible à la figure 6, une encoche 846 est ménagée sur chaque patte 84, sur son côté externe opposé à l'axe X8, au niveau de la zone de jonction entre cette patte 84 et la partie annulaire 82. La géométrie des quatre encoches 846 est telle que, au terme du mouvement d'engagement de la douille 8 équipée de la vis 6 dans un orifice 242, le bord 242B de cet orifice est reçu dans les quatre encoches 846 qui constituent donc ensemble un logement de réception de ce bord 242B. La géométrie des encoches 846 est telle que, dans cette configuration, le bord 242B est pincé dans chacune des encoches 846.

Ensuite, le panneau 24 peut être rapproché de l'armature 22 et maintenu temporairement par rapport à celle-ci grâce à des cales de maintien dont une seule est visible à la figure 3, avec la référence 10. En pratique, plusieurs cales de maintien peuvent être disposées à la périphérie du panneau 24 afin de le centrer par rapport à l'armature 22.

Compte tenu de la mise en place provisoire du panneau 24 sur l'armature 22, les différents sous-ensembles 4 sont alignés avec les pré-perçages 226 prévus dans le montant 22 pour accueillir les vis 6. On comprend que, comme la douille 8 de chaque sous-ensemble 4 est précisément positionnée par rapport à l'orifice 242 dans lequel elle est introduite, du fait de la coopération des encoches 846 et du bord 242B, et du fait que la vis 6 est précisément positionnée dans la douille 8 du fait de la coopération de la collerette 6 et du logement L8, chaque vis 6 est correctement alignée avec le pré-perçage 226 du montant 222 de l'armature 22 dans lequel elle doit être vissée.

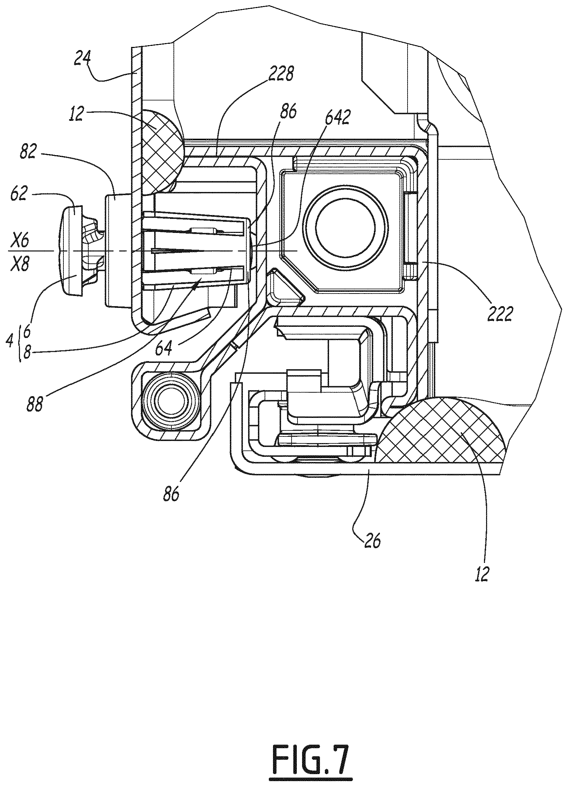

On est alors dans la configuration de la figure 7 où l'extrémité 642 de la tige 64 de la vis 6 est en appui contre ou au voisinage immédiat du montant 222, sans être vissée dans son pré-perçage 226. Dans cette configuration, un joint 12 porté par le panneau 24 est en appui contre une nervure 228 du montant 222.

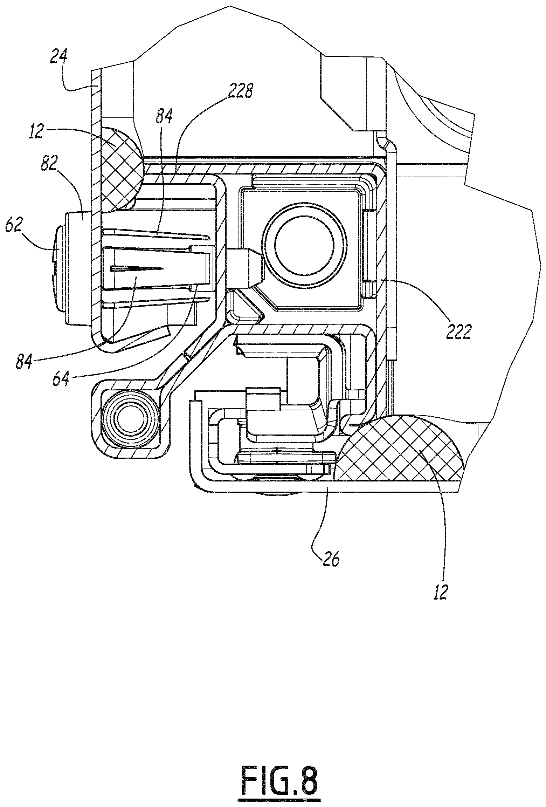

A partir de cette position, il est possible d'entraîner la vis 6 en rotation autour de son axe X6, au moyen d'un outil approprié introduit dans l'empreinte 622, pour visser cette vis dans le pré-perçage 226 correspondant du montant 222, ce qui permet de passer de la configuration de la figure 7 à celle des figures 3, 8 et 9 où l'extrémité 642 de la tige 64 traverse le perçage qu'elle a elle-même défini dans le montant 222, en façonnant le bord du pré-perçage 226.

La vis 6 est alors dans une deuxième configuration par rapport à la douille 8, où son extrémité 642 dépasse de la douille 8 sur une longueur L2, mesurée parallèlement aux axes X6 et X8, qui a une valeur supérieure à celle de la longueur L1. En d'autres termes, dans cette deuxième configuration, la vis 6 dépasse plus de la douille 8 que dans la première configuration, par rapport aux extrémités 842 des pattes 84.

Le passage de la vis 6 de sa première configuration vers sa deuxième configuration par rapport à la douille 8 a lieu au moyen d'un écartement des extrémités 842 des pattes 84 pour laisser passer la collerette 66 entre elles, ce qui a lieu moyennant une déformation élastique des pattes 84 et une rupture des pontets 86. Avant leur rupture, c'est-à-dire dans la première configuration, ces pontets garantissent la complémentarité de formes entre le logement L8 et la collerette 66. Cette complémentarité de formes n'a plus lieu d'être dans la deuxième configuration de la vis 6 par rapport à la douille 8.

Lors du passage de la vis 6 de sa première configuration vers sa deuxième configuration, la collerette 66 écarte les extrémités 842 des pattes 84 radialement par rapport à l'axe X8, ce qui a pour effet de resserrer les encoches externes 846 prévues à la base de ces pattes, du côté de la partie annulaire 82, ce qui augmente l'effort de pincement exercé par la douille 8 sur le bord 242B.

Dans la deuxième configuration de la vis 6, la collerette 66 est en appui contre le voile du montant 222 dans lequel est ménagé le perçage où est vissée la vis 6. En d'autres termes, la collerette 66 forme une butée à l'enfoncement par vissage de la vis 66 dans le montant 222. En conséquence, il peut être garanti que le panneau 24, contre lequel viennent en appui la tête 62 de la vis 6 et la partie annulaire 82 de la douille 8, est disposé à une distance du montant 22, mesurée parallèlement aux axes X6, X8 et X242 confondus, qui est égale, au jeu de fonctionnement près, à la longueur L6. Ainsi, le panneau 24 ne risque pas d'être déformé plastiquement sous l'effet de l'effort exercé du fait d'un vissage trop important de la vis 6 dans le montant 222.

Pour autant, l'opérateur peut être informé qu'il doit visser la vis 6 jusqu'à ce que la collerette 66 vienne en butée contre le montant 222, ce qui assure un effort suffisant pour plaquer efficacement le joint 12 contre le montant 222, en pratique contre sa nervure 228. L'appui de la collerette 66 contre le montant 222 augmente brutalement l'effort que doit exercer l'opérateur pour visser la vis 6 dans le montant 222, ce que l'opérateur détecte aisément, qu'il travaille à la main ou avec une visseuse qui peut être réglée pour ne pas dépasser un effort nominal correspondant à celui qui est exercé au moment où la collerette 66 entre en contact avec le montant 222.

Ainsi, la butée formée par la collerette 66 et le fait que les axes X6, X8 et X242 sont correctement alignés par rapport à l'axe du pré-perçage du montant 222 assure que l'effort de plaquage du joint 12 contre le montant 222 a une intensité adaptée, ni trop élevée, ni trop basse.

En passant de sa première configuration à sa deuxième configuration par rapport à la douille 4, la vis 6 voit ses dents 68 s'engager complètement dans les logements 882 au point que ces dents 68 font saillie vers l'extérieur de la douille 8 à travers les fentes 88, entre les pattes 84, et qu'elles viennent gratter le bord 242B de l'orifice 242, plus particulièrement une arête de jonction entre ce bord et la surface extérieure du panneau 24 lorsque la vis progresse dans le pré-perçage 226 correspondant. Ceci a pour effet de retirer localement un produit de revêtement, tel qu'une peinture ou un vernis, appliqué(e) préalablement sur le panneau 24 pour éviter qu'il ne s'oxyde. La vis est alors en contact avec l'âme du panneau 24, ce qui assure une continuité électrique entre la vis 6 et le panneau 24. D'autre part, une continuité électrique est assurée entre la vis 6 et le montant 222, au niveau de l'extrémité 642 et du perçage du montant car le filet de la vis est en contact intime avec le bord de ce perçage qu'il a façonné. Ainsi, le panneau 24 est relié électriquement au montant 222 sans avoir besoin d'utiliser pour cela un câble spécifique dit « câble de mise à la terre ». On remarque qu'une liaison équipotentielle telle que mentionnée ci-dessus, entre le panneau 24 et l'armature 222, a lieu au niveau de chacun des sous-ensembles 4 c'est-à-dire en huit points dans l'exemple des figures.

Au vu de ce qui précède, la mise en place du sous-ensemble 4 permet, grâce à la douille 8, de pré-positionner la vis 6 par rapport à l'orifice 242 du panneau 24. En outre, le serrage de la vis 6 dans le perçage du montant 222 permet à la fois d'assurer un ancrage mécanique efficace, de comprimer le joint 12 contre le montant 222 avec un effort d'intensité choisie et d'assurer une liaison équipotentielle entre le panneau 24 et l'armature 22.

L'invention est représentée dans le cas où l'armoire électrique 2 comprend plusieurs panneaux 24. Elle s'applique dès lors que l'armoire électrique comprend un panneau disposé sur un de ses côtés ou au niveau de son plafond, les autres côtés pouvant être obturés d'une autre façon.

Selon une autre variante, des pré-perçages 226 peuvent être prévus sur les traverses 224 à la place de ou en complément de ceux prévus sur les montants 222. Par exemple, si le plafond 24 est rapporté sur l'armature 22 avec des sous-ensembles 4, les pré-perçages sont exclusivement ménagés dans les traverses 224.

Les modes de réalisation et les variantes mentionnés ci-dessus peuvent être combinés pour générer de nouveaux modes de réalisation de l'invention.

## Revendications

1. Armoire électrique (2) comprenant une armature (22) et au moins un panneau (24) rapporté sur cette armature au moyen d'au moins une vis auto-taraudeuse (6) qui traverse un orifice (242) ménagé dans le panneau et qui est vissée dans l'armature, **caractérisée en ce que** l'armoire comprend également une douille (8) de pré-positionnement de la vis (6) par rapport à l'orifice (242) du panneau (24), **en ce que** la vis peut être reçue dans la douille dans une première configuration, où un axe longitudinal (X6) de la vis s'étend selon un axe (X8) défini par la douille, et une deuxième configuration, où une extrémité (642) d'une tige (64) de la vis opposée à une tête (62) de la vis dépasse plus de la douille, le long de l'axe défini par la douille, que dans la première configuration, **en ce que** la vis porte une butée (66) de limitation de son enfoncement par vissage dans l'armature (22), **en ce que** la vis porte au moins un relief (68) pour le retrait localisé d'une couche de revêtement appliquée sur le panneau et **en ce que** la douille est pourvue d'un logement (882) de réception de chaque relief de la vis, ce logement étant disposé de telle sorte que, lorsque la vis est dans la deuxième configuration, le relief fait saillie à l'extérieur de la douille en direction du panneau.

2. Armoire électrique selon la revendication 1, **caractérisée en ce que** la douille (8) comprend une portion (822) d'appui surfacique contre le panneau, à la périphérie de l'orifice (242).

3. Armoire selon l'une des revendications précédentes, **caractérisée en ce que** la douille (8) est pourvue d'un volume (846) de réception et de pincement d'un bord (242B) de l'orifice (242) et **en ce que**, lors du passage de la vis (6) de la première configuration à la deuxième configuration, un effort de pincement du bord de l'orifice par la douille augmente.

4. Armoire électrique selon l'une des revendications précédentes, **caractérisée en ce que** la butée est formée par une collerette périphérique (66) ménagée sur la tige (64) de la vis (6).

5. Armoire électrique selon la revendication 4, **caractérisée en ce que**, dans la première configuration, la vis (6) est immobilisée dans la douille (8) par coopération de formes entre la collerette (66) et un logement (L8) de forme correspondante ménagé dans la douille.

6. Armoire selon l'une des revendications précédentes, **caractérisée en ce que** la vis (6) porte plusieurs reliefs de retrait localisé de la couche de revêtement formés par des dents (68) disposées autour de sa tige (64), au voisinage de sa tête (62) et **en ce que** les dents sont configurées pour, lorsque la douille est montée sur le panneau (24) et lorsque la vis est dans la deuxième configuration, venir racler le bord (242B) de l'orifice, plus particulièrement une arête de jonction entre ce bord et une surface du panneau.

7. Armoire électrique selon l'une des revendications précédentes, **caractérisée en ce que** la douille (8) comprend une partie annulaire (82) qui définit un logement (V82) de réception partielle de la tête (62) de la vis (6) et plusieurs pattes (84) qui définissent ensemble l'axe (X8) défini par la douille.

8. Armoire électrique selon la revendication 7, **caractérisée en ce que** les pattes (84) sont reliées par des pontets sécables (86) qui sont rompus lorsque la vis (6) passe de la première configuration à la deuxième configuration, dans la douille (8).

9. Armoire électrique selon les revendications 6 et 7, **caractérisée en ce que** les logements (882) de réception des dents (68) formant les reliefs de retrait localisé de la couche de revêtement sont décalés angulairement, autour de l'axe (X8) défini par la douille, par rapport aux pattes (84).

10. Armoire selon l'une des revendications précédentes, **caractérisée en ce que** la douille (8) est une pièce monobloc en matériau synthétique, notamment en polyamide.

## Patentansprüche

1. Schaltschrank (2), umfassend ein Gestell (22) und mindestens eine Platte (24), die mittels mindestens einer selbstschneidenden Schraube (6), die durch eine in der Platte ausgebildete Öffnung (242) verläuft und in das Gestell eingeschraubt ist, auf dieses Gestell aufgesetzt ist, **dadurch gekennzeichnet, dass** der Schrank auch eine Hülse (8) zur Vorpositionierung der Schraube (6) in Bezug auf die Öffnung (242) der Platte (24) umfasst, dass die Schraube in der Hülse in einer ersten Konfiguration, in der sich eine Längsachse (X6) der Schraube entlang einer durch die Hülse definierten Achse (X8) erstreckt, und einer zweiten Konfiguration, in der ein Ende (642) eines Schafts (64) der Schraube, das einem Kopf (62) der Schraube gegenüberliegt, entlang der durch die Hülse definierten Achse weiter aus der Hülse herausragt als in der ersten Konfiguration, indem die Schraube einen Anschlag (66) zur Begrenzung ihres Eindrückens durch Einschrauben in die Armatur (22) trägt, aufgenommen werden kann, dass die Schraube mindestens ein Relief (68) zum örtlichen Entfernen einer auf die Platte aufgebrachten Beschichtungsschicht trägt und dass die Hülse mit einer Aufnahme (882) zum Aufnehmen von jedem Relief der Schraube versehen ist, wobei diese Aufnahme derart angeordnet ist, dass, wenn die Schraube in der zweiten Konfiguration ist, das Relief außerhalb der Hülse in Richtung der Platte hervorsteht.

2. Schaltschrank nach Anspruch 1, **dadurch gekennzeichnet, dass** die Hülse (8) einen Abschnitt (822) zur flächigen Anlage an der Platte an dem Umfang der Öffnung (242) umfasst.

3. Schrank nach einem der vorherigen Ansprüche, **dadurch gekennzeichnet, dass** die Hülse (8) mit einem Volumen (846) zur Aufnahme und zum Einklemmen eines Rands (242B) der Öffnung (242) versehen ist und dass bei dem Übergang der Schraube (6) von der ersten Konfiguration in die zweite Konfiguration eine Kraft zum Einklemmen des Rands der Öffnung durch die Hülse zunimmt.

4. Schaltschrank nach einem der vorherigen Ansprüche, **dadurch gekennzeichnet, dass** der Anschlag durch einen umlaufenden Bund (66) gebildet ist, der auf dem Schaft (64) der Schraube (6) angeordnet ist.

5. Schaltschrank nach Anspruch 4, **dadurch gekennzeichnet, dass** die Schraube (6) in der ersten Konfiguration durch Formschluss zwischen dem Bund (66) und einer entsprechend geformten Aufnahme (L8), die in der Hülse gebildet ist, in der Hülse (8) immobilisiert ist.

6. Schrank nach einem der vorherigen Ansprüche, **dadurch gekennzeichnet, dass** die Schraube (6) mehrere Erhebungen zum örtlichen Entfernen der Beschichtungsschicht trägt, die durch Zähne (68) gebildet sind, die um ihren Schaft (64) herum in der Nähe ihres Kopfs (62) angeordnet sind, und dass die Zähne konfiguriert sind, dass sie, wenn die Hülse auf der Platte (24) montiert ist und die Schraube in der zweiten Konfiguration ist, den Rand (242B) der Öffnung, insbesondere eine Verbindungskante zwischen diesem Rand und einer Oberfläche der Platte, abschaben.

7. Schaltschrank nach einem der vorherigen Ansprüche, **dadurch gekennzeichnet, dass** die Hülse (8) einen ringförmigen Abschnitt (82), der eine Aufnahme (V82) zur teilweisen Aufnahme des Kopfs (62) der Schraube (6) definiert, und mehrere Laschen (84), die zusammen die durch die Hülse definierte Achse (X8) definieren, umfasst.

8. Schaltschrank nach Anspruch 7, **dadurch gekennzeichnet, dass** die Laschen (84) durch abbrechbare Brücken (86) verbunden sind, die gebrochen werden, wenn die Schraube (6) in der Hülse (8) von der ersten Konfiguration in die zweite Konfiguration wechselt.

9. Schaltschrank nach den Ansprüchen 6 und 7, **dadurch gekennzeichnet, dass** die Aufnahmen (882) zum Aufnehmen der Zähne (68), die Reliefs zum örtlichen Entfernen der Beschichtungsschicht bilden, um die durch die Hülse definierte Achse (X8) in Bezug auf die Laschen (84) winklig versetzt sind.

10. Schrank nach einem der vorherigen Ansprüche, **dadurch gekennzeichnet, dass** die Hülse (8) ein einteiliges Teil aus synthetischem Material, insbesondere aus Polyamid, ist.

## Claims

1. An electrical cabinet (2) comprising a frame (22) and at least one panel (24) attached to this frame by means of at least one self-tapping screw (6) which passes through an orifice (242) provided in the panel and which is screwed into the frame, **characterised in that** the cabinet further comprises a sleeve (8) for pre-positioning the screw (6) relative to the hole (242) in the panel (24), **in that** the screw can be received in the sleeve in a first configuration, where a longitudinal axis (X6) of the screw extends along an axis (X8) defined by the sleeve, and a second configuration in which an end (642) of a shank (64) of the screw opposite a head (62) of the screw protrudes further from the sleeve along the axis defined by the sleeve than in the first configuration, **in that** the screw carries a stop (66) for limiting its driving into the frame (22) by screwing, **in that** the screw carries at least one relief (68) for the localised removal of a coating layer applied to the panel, and **in that** the sleeve is provided with a housing (882) for receiving each relief of the screw, this housing being arranged such that, when the screw is in the second configuration, the relief projects outside the sleeve towards the panel.

2. The electrical cabinet according to claim 1, **characterised in that** the sleeve (8) comprises a surface bearing portion (822) against the panel, at the periphery of the orifice (242).

3. The cabinet according to one of the preceding claims, **characterised in that** the sleeve (8) is provided with a volume (846) for receiving and clamping an edge (242B) of the orifice (242) and **in that**, when the screw (6) passes from the first configuration to the second configuration, a clamping force on the edge of the orifice by the sleeve increases.

4. The electrical cabinet according to one of the preceding claims, **characterised in that** the stop is formed by a peripheral collar (66) provided on the shaft (64) of the screw (6).

5. The electrical cabinet according to claim 4, **characterised in that** in the first configuration the screw (6) is fixed in the sleeve (8) by positive engagement between the collar (66) and a correspondingly shaped recess (L8) in the sleeve.

6. The cabinet according to one of the preceding claims, **characterised in that** the screw (6) carries a plurality of localised coating layer removal reliefs formed by teeth (68) disposed around its shank (64), in the vicinity of its head (62), and **in that** the teeth are configured so as, when the socket is mounted on the panel (24) and when the screw is in the second configuration, to scrape off the edge (242B) of the hole, more particularly a junction edge between this edge and a surface of the panel.

7. The electrical cabinet according to one of the preceding claims, **characterised in that** the sleeve (8) comprises an annular portion (82) which defines a housing (V82) for partially receiving the head (62) of the screw (6) and a plurality of tabs (84) which together define the axis (X8) defined by the sleeve.

8. The electrical cabinet according to claim 7, **characterised in that** the tabs (84) are connected by breakable bridges (86) which are broken when the screw (6) is moved from the first configuration to the second configuration in the sleeve (8).

9. The electrical cabinet according to claims 6 and 7, **characterised in that** the housings (882) for receiving the teeth (68) forming the localised coating layer removal reliefs are angularly offset, about the axis (X8) defined by the sleeve, with respect to the tabs (84).

10. The cabinet according to one of the preceding claims, **characterised in that** the sleeve (8) is a one-piece part made of synthetic material, in particular polyamide.
